# EUROPEAN PATENT APPLICATION

(11) **EP 1 903 440 A2**
(43) Date of publication of application: **26.03.2008**
(21) Application number: 07112482.0
(22) Date of filing: 13.07.2007
(51) Int. Cl.: G06F 11/00

(54) **Local controller for reconfigurable processing elements**

(30) Priority: 18.07.2006 US 458316
(71) Applicant: Honeywell International Inc., Morristown, NJ 07962 (US)
(72) Inventor: Ramos, Jeremy, Tampa, FL 33626 (US); Lafferty, James E., St. Petersburg, FL 33711-4441 (US); Moseley, Nathan P., Hillsboro, OR 97124 (US); Noah, Jason C., Redington Shores, FL 33708 (US); Waltuch, Jason, St. Petersburg, FL 33702 (US)
(74) Representative: Haley, Stephen

(57) **Abstract**

A reconfigurable computer is disclosed. The computer includes a controller and at least one reconfigurable processing element communicatively coupled to the controller. The controller is operable to read at least a first portion of a respective configuration of each of the plurality of reconfigurable processing elements and refresh at least a portion of the respective configuration of the reconfigurable processing element if the first portion of the configuration of the reconfigurable processing element has changed since the first portion was last checked.

## Description

The present application is related to commonly assigned and co-pending U.S. Patent Application Serial No. 10/897,888 (Attorney Docket No. H0003944-5802) entitled "RECONFIGURABLE COMPUTING ARCHITECTURE FOR SPACE APPLICATIONS," filed on July 23, 2004, which is incorporated herein by reference, and also referred to here as the '888 Application.

In one type of space application, a device traveling in space transmits data to a device located on Earth. A device traveling in space is also referred to here as a "space device." Examples of space devices include, without limitation, a satellite and a space vehicle. A device located on Earth is also referred to here as an "Earth-bound device." An example of an Earth-bound device is a mission control center. Data that is transmitted from a space device to an Earth-bound device is also referred to here as "downstream data" or "payload data." Examples of payload data include, without limitation, scientific data obtained from one or more sensors or other scientific instruments included in or on a space device.

In some applications, the quantity of payload data that is collected by and transmitted from a space device to an Earth-bound device approaches or even exceeds the physical limits of the communication link between the space device and the Earth-bound device. One approach to reducing the quantity of payload data that is communicated from a space device to an Earth-bound device is to increase the amount of processing that is performed on the space device. In other words, the space device processes the raw payload data that otherwise would be included in the downstream data. Typically, the resulting processed data is significantly smaller in size than the raw payload data. The resulting data from such processing is then transmitted from the space device to the Earth-bound device as the downstream data.

One way to process raw payload data on a space device employs application-specific integrated circuits (ASICs). Application-specific integrated circuits, while efficient, typically are mission-specific and have limited scalability, upgradeability, and re-configurability. Another way to process raw payload data makes use of anti-fuse field programmable gate arrays (FPGAs). Such an approach typically lowers implementation cost and time. Also, anti-fuse FPGAs typically exhibit a high degree of tolerance to radiation. However, anti-fuse FPGAs are typically not re-programmable (that is, reconfigurable). Consequently, an anti-fuse FPGA that has been configured for one application is not reconfigurable for another application.

Another way to process such raw payload data makes use of re-programmable FPGAs. However, re-programmable FPGAs are typically susceptible to single event upsets. A single event upset (SEU) occurs when an energetic particle penetrates the FPGA (or supporting) device at high speed and high kinetic energy. For example, the energetic particle can be an ion, electron, or proton resulting from solar radiation or background radiation in space. The energetic particle interacts with electrons in the device. Such interaction can cause the state of a transistor in an FPGA to reverse. That is, the energetic particle causes the state of the transistor to change from a logical "0" to a logical "1" or from a logical "1" to a logical "0." This is also referred to here as a "bit flip." The interaction of an energetic particle and electrons in an FPGA device can also introduce a transient current into the device.

Payload data applications continue to operate with high amounts of communication interference. Current monitoring techniques limit the re-programmable FPGAs from recovering within a minimal recovery time. The recovery time from one or more single event upsets is critical, especially in operating environments susceptible to high amounts of radiation.

In one embodiment, a reconfigurable computer is provided. The computer includes a controller and at least one reconfigurable processing element communicatively coupled to the controller. The controller is operable to read at least a first portion of a respective configuration of each of the plurality of reconfigurable processing elements and refresh at least a portion of the respective configuration of the reconfigurable processing element if the first portion of the configuration of the reconfigurable processing element has changed since the first portion was last checked.

### IN THE DRAWINGS

Figure 1 is a block diagram of an embodiment of a space payload processing system;

Figure 2 is a block diagram of an embodiment of a reconfigurable computer for use in payload processing on a space device;

Figure 3 is a block diagram of an embodiment of a configuration interface for a reconfigurable computer; and

Figure 4 is a flow diagram illustrating an embodiment of a method for controlling at least two reconfigurable processing elements.

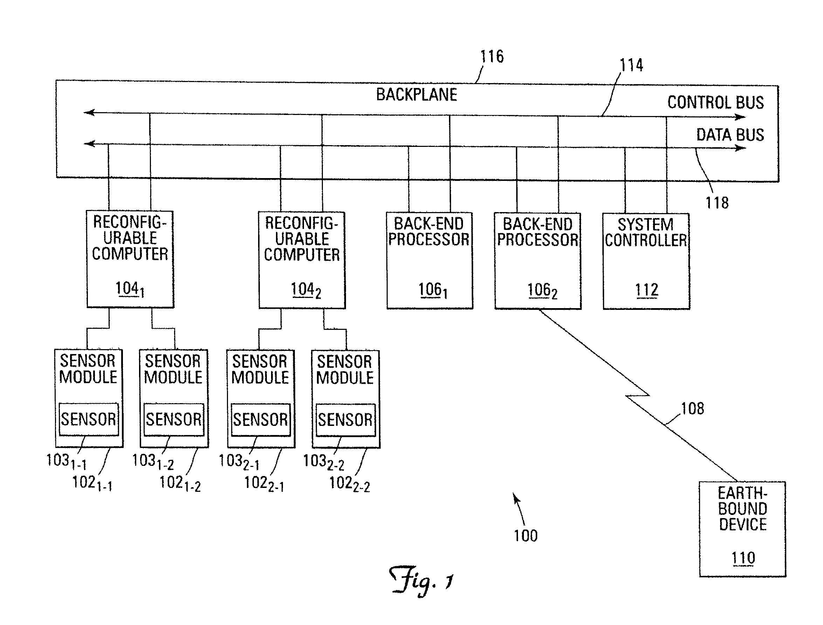

Figure 1 is a block diagram of an embodiment of a space payload processing system 100, as described in the '888 application. Embodiments of system 100 are suitable for use, for example, in space devices such as satellites and space vehicles. System 100 includes sensor modules 102₁₋₁ to 102₂₋₂. Each of sensor modules 102₁₋₁ to 102₂₋₂ is a source of raw payload data that is to be processed by system 100. It is to be understood, however, that in other embodiments, other sources of raw payload data are used.

Each of sensor modules 102₁₋₁ to 102₂₋₂ comprise sensors 103₁₋₁ to 103₂₋₂. In one embodiment, sensors 103₁₋₁ to 103₂₋₂ comprise active and/or passive sensors. Each of sensors 103₁₋₁ to 103₂₋₂ generate a signal that is indicative of a physical attribute or condition associated with that sensor 103. Sensor modules 102₁₋₁ to 102₂₋₂ include appropriate support functionality (not shown) that, for example, perform analog-to-digital conversions and drive the input/output interface necessary to supply sensor data to other portions of system 100. It is noted that for simplicity in description, a total of four sensor modules 102₁₋₁ to 102₂₋₂ and four sensors 103₁₋₁ to 103₂₋₂ are shown in Figure 1. However, it is understood that in other embodiments of system 100 different numbers of sensor modules 101 and sensors 103 (for example, one or more sensor modules and one or more sensors) are used.

For example, in one embodiment, each of sensor modules 102₁₋₁ to 102₂₋₂ includes an array of optical sensors such as an array of charge coupled device (CCD) sensors or complimentary metal oxide system (CMOS) sensors. In another embodiment, an array of infrared sensors is used. The array of optical sensors, in such an embodiment, generates pixel image data that is used for subsequent image processing in system 100. In other embodiments, other types of sensors are used.

The data output by sensor modules 102₁₋₁ to 102₂₋₂ comprise raw sensor data that is processed by system 100. More specifically, the sensor data output by 102₁₋₁ to 102₂₋₂ is processed by reconfigurable computers 104₁ to 104_{N}. For example, in one embodiment where sensor modules 102₁₋₁ to 102₂₋₂ output raw image data, reconfigurable computers 104₁ to 104₂ perform one or more image processing operations such as RICE compression, edge detection, or Consultative Committee of Space Data Systems (CCSDS) protocol communications.

The processed sensor data is then provided to back-end processors 106₁ and 106₂. Back-end processors 106₁ and 106₂ receive the processed sensor data as input for high-level control and communication processing performed by reconfigurable computers 104₁ and 104₂. In the embodiment shown in system 100, back-end processor 106₂ assembles appropriate downstream packets that are transmitted via a communication link 108 to an Earth-bound device 110. At least a portion of the downstream packets include the processed sensor data (or data derived from the processed sensor data) that was received from reconfigurable computers 104₁ and 104₂. The communication of payload-related data within and between the various components of system 100 is also referred to here as occurring in the "data path." It is noted that for simplicity in description, a total of two reconfigurable computers 104₁ and 104₂ and two back-end processors 106₁ and 106₂ are shown in Figure 1. However, it is understood that in other embodiments of system 100 different numbers of reconfigurable computers 104 and back-end processors 106 (for example, one or more reconfigurable computers and one or more back-end processors) are used.

System 100 also includes system controller 112. System controller 112 monitors and controls the operation of the various components of system 100. For example, system controller 112 manages the configuration and reconfiguration of reconfigurable computers 104₁ and 104₂. System controller 112 is further responsible for control of one or more programmable reconfiguration refresh and readback intervals. Communication of control data within and between the various components of system 100 is also referred to here as occurring in the "control path."

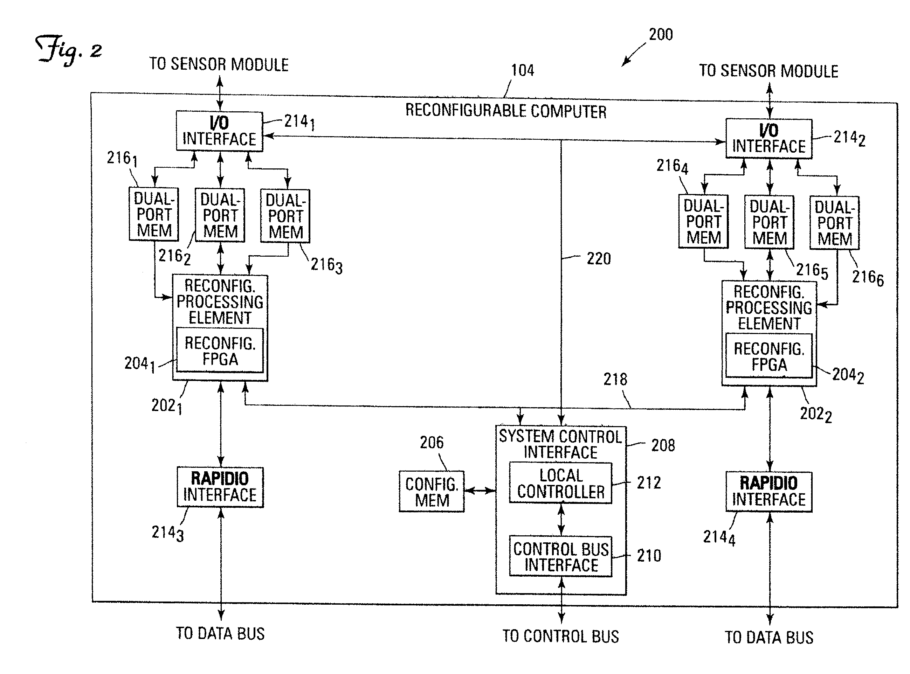

Reconfigurable computers 104₁ and 104₂ are capable of being configured and re-configured. For example, reconfigurable computers 104₁ and 104₂ are capable of being configured and re-configured at runtime. That is, processing that is performed by reconfigurable computers 104₁ and 104₂ is changed while the system 100 is deployed (for example, while the system 100 is in space). In one embodiment, each of reconfigurable computers 104₁ and 104₂ is implemented using one or more reconfigurable processing elements. One such embodiment is described in further detail below with respect to Figure 2.

In one embodiment, re-configurability of reconfigurable computers 104₁ and 104₂ is used to fix problems in, or add additional capabilities to, the processing performed by each of reconfigurable computers 104₁ and 104₂. For example, while system 100 is deployed, new configuration data for reconfigurable computer 104, is communicated from earth-bound device 110 to system 100 over communication link 108. Reconfigurable computer 104₁ uses the new configuration data to reconfigure reconfigurable computer 104₁ (that is, itself).

Further, the re-configurability of reconfigurable computers 104₁ and 104₂ allows reconfigurable computers 104₁ and 104₂ to operate in one of multiple processing modes on a time-sharing basis. For example, in one usage scenario, reconfigurable computer 104₂ is configured to operate in a first processing mode during a first portion of each day, and to operate in a second processing mode during a second portion of the same day. In this way, multiple processing modes are implemented with the same reconfigurable computer 104₂ to reduce the amount of resources (for example, cost, power, and space) used to implement such multiple processing modes.

In system 100, each of reconfigurable computers 104₁ and 104₂ and each of back-end processors 106₁ and 106₂ are implemented on a separate board. Each of the separate boards communicates control information with one another over control bus 114 such as a Peripheral Component Interconnect (PCI) bus or a compact PCI (cPCI) bus. Control bus 114, for example, is implemented in backplane 116 that interconnects each of the boards. In the example embodiment of system 100 shown in Figure 1, at least some of the boards communicate with one another over one or more data busses 118 (for example, one or more buses that support the RAPIDIO® interconnect protocol). In such an implementation, sensor modules 102₁₋₁ to 102₂₋₂ are implemented on one or more mezzanine boards. Each mezzanine board is connected to a corresponding reconfigurable computer board using an appropriate input/output interface such as the PCI Mezzanine Card (PMC) interface.

Figure 2 is a block diagram of an embodiment of a reconfigurable computer 104 for use in payload processing on a space device 200. The embodiment of reconfigurable computer 104 shown includes reconfigurable processing elements (RPEs) 202₁ and 202₂, similar to the RPEs described in the '888 application. As similarly noted in the '888 application, embodiments of reconfigurable computer 104 are suitable for use in or with system 100 as described with respect to Figure 1 above. It is to be understood that other embodiments and implementations of reconfigurable computer 104 are implemented in other ways (for example, with two or more RPEs 202).

RPEs 202₁ and 202₂ comprise reconfigurable FPGAs 204₁ and 204₂ that are programmed by loading appropriate programming logic (also referred to here as an "FPGA configuration" or "configuration") as discussed in further detail below. Each RPE 202₁ and 202₂ is configured to perform one or more payload processing operations. Reconfigurable computer 104 also includes input/output (I/O) interfaces 214₁ and 214₂. Each of the two I/O interfaces 214₁ and 214₂ are coupled to a respective sensor module 102 of Figure 1 that receives raw payload data for processing by the reconfigurable processing elements 202.

I/O interfaces 214₁ and 214₂ and RPEs 202₁ and 202₂ are coupled to one another with a series of dual-port memory devices 216₁ to 216₆. This obviates the need to use multi-drop buses (or other interconnect structures) that are more susceptible to one or more SEUs. Each of a first group of dual-port memory devices 216₁ to 2163 has a first port coupled to I/O interface 214₁. I/O interface 214₁ uses the first port of each of memory devices 216₁ to 216₃ to read data from and write data to each of memory devices 216₁ to 216₃. RPE 202₁ is coupled to a second port of each of memory devices 216₁ to 216₃. RPE 202₁ uses the second port of each of memory devices 216₁ to 216₃ to read data from and write data to each of memory devices 216₁ to 216₃. Each of a second group of three dual-port memory devices 216₄ to 2166 has a first port coupled to I/O interface 214₂. I/O interface 2142 uses the first port of each of memory devices 216₄ to 2166 to read data from and write data to each of memory devices 216₄ to 216₆. RPE 202₂ is coupled to a second port of each of memory devices 216₄ to 216₆. RPE 202₂ uses the second port of each of memory devices 216₄ to 216₆ to read data from and write data to each of memory devices 216₄ to 216₆.

In this example embodiment, I/O interfaces 214₃ and 214₄ are RAPIDIO interfaces. Each of RAPIDIO interfaces 214₃ and 214₄ are coupled to a respective back-end processor 106 of Figure 1 over one or more data buses 118 in backplane 116 that supports the RAPIDIO interconnect protocol. Each of RPEs 202₂ to 202₂ is coupled to a respective one of the RAPIDIO interfaces 2143 and 214₄ in order to communicate with the one or more back-end processors 106 of Figure 1.

Reconfigurable computer 104 further includes system control interface 208. System control interface 208 is coupled to each of RPEs 202₂ to 202₂ over configuration bus 218. System control interface 208 is also coupled to each of I/O interfaces 214₁ and 214₂ over system bus 220. System control interface 208 provides an interface by which the system controller 112 of Figure 1 communicates with (that is, monitors and controls) RPEs 202₂ to 202₂ and one or more I/O devices coupled to I/O interfaces 214₁ and 214₂. System control interface 208 includes control bus interface 210. Control bus interface 210 couples system control interface 208 to control bus 114 of Figure 1. System control interface 208 and system controller 112 communicate over control bus 114. In one implementation, control bus interface 210 comprises a cPCI interface.

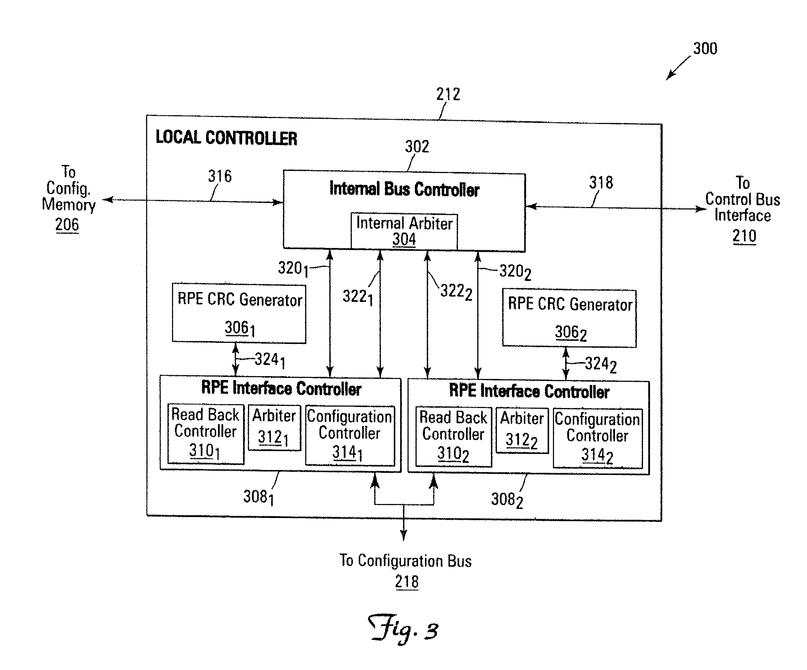

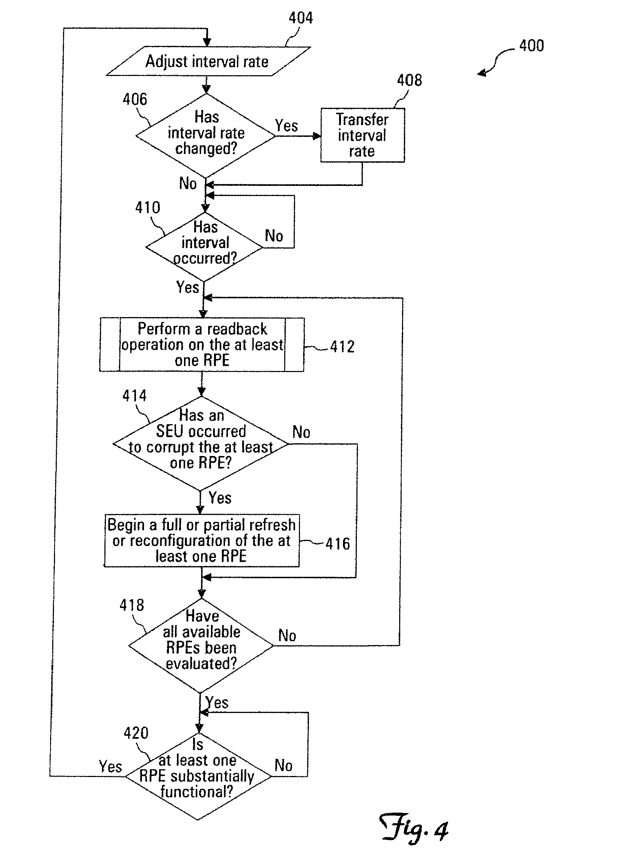

System control interface 208 also includes local controller 212. Local controller 212 carries out various control operations under the direction of system controller 112 of Figure 1. Local controller 212 performs various FPGA configuration management operations as described in further detail below with respect to Figure 3. The configuration management operations performed by local controller 212 include reading an FPGA configuration from configuration memory 206 and loading the FPGA configuration into each of reconfigurable FPGAs 204₁ and 204₂. One or more FPGA configurations are stored in configuration memory 206. In one implementation, configuration memory 206 is implemented using one of a flash random access memory (Flash RAM) and a static random access memory (SRAM). In other embodiments, the one or more FPGA configurations are stored in a different location (for example, in a memory device included in system controller 112). The configuration management operations performed by local controller 212 also include SEU mitigation. Examples of SEU mitigation include periodic and/or event-triggered refreshing of the FPGA configuration and/or FPGA configuration readback and compare. In one embodiment, the SEU mitigation described here (and with respect to Figure 4 below) is performed by local controller 212 for each of RPEs 202₁ and 202₂ that sustain at least one substantial SEU.

In the example embodiment shown in Figure 2, system control interface 208 and configuration memory 206 are implemented using radiation-hardened components and reconfigurable processing elements 202₁ and 202₂ (including reconfigurable FPGAs 204₁ and 204₂), I/O interfaces 214₁ to 214₄, and dual-port memory devices 216₁ to 216₆ are implemented using commercial off the shelf (COTS) components that are not necessarily radiation hardened. COTS components are less expensive, more flexible, and easier to program. Typically, the processing performed in the data path changes significantly more than the processing performed in the control path from mission-to-mission or application-to-application. Using COTS components allows reconfigurable computer 104 to be implemented more efficiently (in terms of time, cost, power, and/or space) than radiation-hardened components such as non-reconfigurable, anti-fuse FPGAs or ASICs. Moreover, by incorporating SEU mitigation techniques in system control interface 208, redundancy-based SEU mitigation techniques such as triple modular redundancy are unnecessary. This reduces the amount of resources (for example, time, cost, power, and/or space) needed to implement reconfigurable computer 104 for use in a given space application with COTS components.

Figure 3 is a block diagram of an embodiment of a configuration interface 300, for a reconfigurable computer. Configuration interface 300 comprises local controller 212, configuration memory 206, control bus interface 210, and configuration bus 218. Configuration memory 206, control bus interface 210, and configuration bus 218 were described above with respect to Figure 2. Local controller 212 comprises internal bus controller 302, RPE CRC generators 306₁ and 306₂, and RPE interface controllers 308₁ and 308₂. It is to be understood that other embodiments and implementations of local controller 212 are implemented in other ways (for example, with two or more RPE CRC generators 306 and two or more RPE interface controllers 308) . Internal bus controller further includes internal arbiter 304. Internal bus controller 302 is directly coupled to each of RPE CRC generators 306₁ and 306₂ by inter-core interfaces 320₁ and 320₂, respectively. Inter-core interfaces 320₁ and 320₂ are internal bi-directional communication interfaces. Internal arbiter 304 is directly coupled to each of RPE interface controllers 308₁ and 308₂ by arbiter interfaces 322₁ and 322₂, respectively. Arbiter interfaces 322₁ and 322₂ are internal bi-directional communication interfaces. Internal arbiter 304 prevents inter-core communications within local controller 212 from occurring concurrently, which may result in an incorrect operation. Each of RPE CRC generators 306₁ and 306₂ is directly coupled to RPE interface controllers 308₁ and 308₂ by CRC interfaces 324₁ and 324₂, respectively. CRC interfaces 324₁ and 324₂ are internal bi-directional communication interfaces.

Internal bus controller 302 is coupled to configuration memory 206 (shown in Figure 2) by configuration memory interface 316. Configuration memory interface 316 is an inter-component bi-directional communication interface. Internal bus controller 302 is also coupled control bus interface 210 (shown in Figure 2) by controller logic interface 318. Controller logic interface 318 is an inter-component bi-directional communication interface. In one implementation, controller logic interface 318 is one of a WISHBONE interface, a cPCI interface, or the like. Each of RPE interface controllers 308₁ and 308₂ are coupled to configuration bus 218 for communication with RPE 202₁ and 202₂ of Figure 2. Each of RPE interface controllers 308₁ and 308₂ further include readback controllers 310₁ and 310₂, arbiters 312₁ and 312₂, and configuration controllers 314₁ and 314₂, respectively, whose operation is further described below. In one implementation, internal arbiter 304 and each of arbiters 312₁ and 312₂ are two-interface, rotational-arbitration state machines. Other implementations are possible.

In operation, a full or partial set of configuration data for each of RPEs 202₁ to 202₂ is retrieved from configuration memory 206 by internal bus controller 302. In this example embodiment, system controller 112 (of Figure 1) determines whether a full or partial set of configuration data is to be analyzed. System control interface 208 is capable of operating at a 50 MHz clock rate (maximum) and will complete one data transfer (for example, a data frame or byte) on every rising edge of the clock during a burst read (readback) or burst write (configuration) operation. In one implementation, local controller 212 operates at a clock rate of 10 MHz. Internal arbiter 304 determines the order in which each RPE interface controllers 308₁ and 308₂ receive the configuration data without causing an interruption in operation of reconfigurable computer 104.

Once each of RPE interface controllers 308₁ and 308₂ receive the configuration data, each of readback controllers 310₁ and 310₂ controls a readback operation of the configuration data. For every readback operation of the configuration data, each of RPE CRC generators 306₁ and 306₂ perform a CRC on a full or partial set of the configuration data. The CRC determines if any configuration data bits have changed since a previous readback of the same configuration data (that is, corrupted due to one or more SEUs). In a situation where a readback CRC calculation does not match a stored CRC, local controller 212 enters an auto-reconfiguration mode. In the example embodiment of Figure 3, auto reconfiguration due to a CRC error is a highest priority. Additionally, local controller 212 provides a CRC error count register for gathering of SEU statistics.

Local controller 212 supports interleaving of readback and reconfiguration (refresh) operations by interleaving priority and order via arbiters 312₁ and 312₂. Arbiters 312₁ and 312₂ are each responsible for arbitration of the configuration data between RPE CRC generator 306₁ (306₂) and configuration controller 314₁ (314₂). Each of configuration controllers 314₁ and 314₂ take in one or more input requests from an internal register file (not shown) and decode which operation to execute. Configuration controller 314₁ (314₂) identifies a desired operation to be executed and makes a request for the transaction to be performed by supporting logic within local controller 212.

Each of configuration controllers 314₁ and 314₂ select an operating mode for multiplexing appropriate data and control signals internally. Once all requested inputs are received, configuration controller 314₁ (314₂) decides which specific request to execute. Once the specific request is granted, configuration controller 314₁ (314₂) issues an access request to arbiter 312₁ (312₂) for access to complete the request. Each request is priority-encoded and implemented in a fair arbitration scheme so no single interface is rejected of a request to access configuration bus 218. Each of configuration controllers 314₁ and 314₂ provide a set of software instructions for local controller 212 with the capability to interface to configuration bus 218 on a cycle-by-cycle basis. Specifically, upon receipt of the access request, configuration controller 314₁ (314₂) outputs the configuration data from configuration memory 206 on configuration bus 218.

Local controller 212 and control bus interface 210 provide one or more independent configuration buses (for example, RPE interface controllers 308₁ and 308₂). In one implementation, RPE interface controllers 308₁ and 308₂ provide simultaneous readback and CRC checking for each of RPE 202₁ and 202₂. Subsequently, simultaneous readback of one configuration of RPE 202₁ (202₂) will occur while RPE 202₂ (202₁) is reconfigured. Further, local controller 212 provides one or more programmable reconfiguration refresh and readback interval rates. Local controller 212 also supports burst read and burst write access. In one implementation, wait states are inserted during back-to-back read/write and write/read operations. Full and partial reconfiguration of RPEs 202₁ and 202₂ occurs within a minimum number of operating cycles and substantially faster than previous (that is, software-based) SEU mitigation operations.

Figure 4 is a flow diagram illustrating a method 400 for controlling at least two reconfigurable processing elements. In the example embodiment shown in Figure 4, method 400 is implemented using system 100 and reconfigurable computer 104 of Figures 1 and 2, respectively. In particular, at least a portion of method 400 is implemented by local controller 212 of system control interface 210. In other embodiments, however, method 400 is implemented in other ways.

Once a refresh interval value is established (or adjusted) at block 404, method 400 begins the process of monitoring the configuration of each available RPE for possible corruption due to an occurrence of a single event upset. A primary function of method 400 is to automatically reconfigure a corrupted configuration of a RPE within a minimum amount of operating cycles. In one implementation, method 400 substantially improves completion time for a full or partial refresh or reconfiguration to maintain operability of the space payload processing application.

A determination is made about whether the refresh interval rate has changed from a previous or default level (checked in block 406). This determination is made in system controller 112 described above with respect to Figure 1. If the refresh interval level has changed, the system controller 112 transfers the refresh interval level to the local controller 212 at block 408, and proceeds to block 410. If the refresh interval level has not changed, or the refresh interval level is fixed at a (static) predetermined level, method 400 continues at block 410. At block 410, a determination is made about whether the current refresh interval has elapsed. Until the refresh interval elapses, processing associated with block 410 is repeated.

At block 412, method 400 begins evaluating the configuration status for a RPE (referred to here as the "current" RPE) by performing a readback operation. In one implementation of such an embodiment, the readback operation is performed by the RPE interface controller 308 for the current RPE. The local controller 212 reads the current configuration of the reconfigurable FPGA for the current RPE and compares at least a portion of the read configuration to a known-good value associated with the current configuration. If the read value does not match the known-good value, the configuration of the current RPE is considered corrupt. In one implementation, such a readback operation is performed by reading each byte (or other unit of data) of the configuration of the FPGA for the current RPE and comparing that byte to a corresponding byte of the corresponding configuration stored in configuration memory 206. In other words, local controller 212 performs a byte-by-byte compare. In another implementation, one or more CRCs (or other error correction code) values are calculated for the current configuration of the FPGA for the current RPE by a respective RPE CRC generator.

If the configuration for the current RPE is corrupt (checked in block 414), method 400 begins a full or partial reconfiguration (refresh) of the current RPE 202 at block 416. The determination as to whether to perform a full or partial reconfiguration is made by system controller 112 of Figure 1. If the readback operation performed in block 412 does not reveal corruption of the configuration of the current RPE 202, method 400 proceeds directly to block 418.

At block 418, method 400 determines whether all available RPEs have been evaluated. If not, method 400 returns to block 412 to evaluate the configuration status for the next available RPE. When all available RPEs have been evaluated, method 400 waits until at least one of the available RPEs is substantially functional (checked in block 422) at which time method 400 returns to block 404.

In one example of the operation of method 400 in the system 100 of Figure 1, when RPE 202₁ is to be configured (or reconfigured), an appropriate configuration is read from configuration memory 206 and loaded into the reconfigurable FPGA 204₁. Similar operations occur to configure RPE 202₂. Each of RPE 202₁ and RPE 202₂ is configured, for example, when the reconfigurable computer 104 of Figure 2 initially boots after an initial system power on or after a system reset. In some embodiments of reconfigurable computer 104 that support timesharing multiple operating modes, the reconfigurable computer 104 is configured so that each time the operating mode of reconfigurable computer 104 changes, the configuration for the new operating mode is read from configuration memory 206 and loaded into the reconfigurable FPGA for the respective RPEs. Also, in such an example, RPE 202₁ and RPE 202₂ are configured to perform, as a part of one or more SEU mitigation operations, a "refresh" operation in which the configuration of the respective reconfigurable FPGA 204₁ and FPGA 204₂ is reloaded.

## Claims

1. A reconfigurable computer (104) comprising:
a controller (208);
at least one reconfigurable processing element (202) communicatively coupled to the controller;
wherein the controller is operable to read at least a first portion of a respective configuration of each of the plurality of reconfigurable processing elements and refresh at least a portion of the respective configuration of the reconfigurable processing element if the first portion of the configuration of the reconfigurable processing element has changed since the first portion was last checked.

2. The reconfigurable computer of claim 1, wherein the controller determines if the first portion has changed since the first portion was last checked using a cyclic redundancy code (CRC) generated for the first portion of the configuration.

3. The reconfigurable computer of claim 2, further comprising a CRC generator (306), communicatively coupled to the controller, to generate the CRC for the first portion of the configuration.

4. The reconfigurable computer of claim 1, further comprising a configuration memory (206) communicatively coupled to the controller.

5. The reconfigurable computer of claim 4, wherein the configuration memory comprises a radiation-hardened memory device.

6. The reconfigurable computer of claim 1, wherein the controller comprises a configuration controller (314) to read the first portion of the configuration of the reconfigurable processing element and a read-back controller (310) to determine if the first portion has changed since the first portion was last checked.

7. The reconfigurable computer of claim 1, wherein the configuration controller refreshes the at least a portion of the configuration of the reconfigurable processing element if the first portion of the configuration of the reconfigurable processing element has changed since the first portion was last checked.

8. The reconfigurable computer of claim 1, wherein the reconfigurable processing element comprises a reconfigurable field programmable gate array (204).

9. The reconfigurable computer of claim 1, wherein the controller refreshes the at least a portion of the configuration of the reconfigurable processing element if the first portion of the configuration of the reconfigurable processing element has changed since the first portion was last checked by doing at least one of a partial refresh and a full refresh.
